# EUROPÄISCHE PATENTSCHRIFT

(11) **EP 1 309 874 B1**
(45) Veröffentlichungstag und Bekanntmachung des Hinweises auf die Patenterteilung: **01.03.2006**
(21) Anmeldenummer: 01984516.3
(22) Anmeldetag: 25.06.2001
(51) Int. Cl.: G01R 21/12

(54) **LEISTUNGSSENSOR**
POWER SENSOR
CAPTEUR DE PUISSANCE

(30) Priorität: 14.08.2000 DE 10039665
(43) Veröffentlichungstag der Anmeldung: 14.05.2003
(73) Patentinhaber: Rohde & Schwarz GmbH & Co. KG, 81671 München (DE)
(72) Erfinder: BRATFISCH, Toralf, 81673 München (DE); DIESTELHORST, Arnd, 81667 München (DE); KATZER, Michael, 81543 München (DE); REICHEL, Thomas, 85598 Baldham (DE)
(74) Vertreter: Körfer, Thomas
(86) Internationale Anmeldenummer: PCT/EP2001/007162
(87) Internationale Veröffentlichungsnummer: WO 2002/014880

(56) Entgegenhaltungen:
- US-A- 544 396
- US-A- 4 873 484
- US-A- 4 943 764
- US-A- 5 204 613

## Beschreibung

Die Erfindung betrifft einen Leistungssensor zum Messen der mittleren Leistung modulierter oder unmodulierter Hochfrequenz- bzw. Mikrowellen-Signale über einen großen Dynamikbereich.

Leistungssensoren sind in den verschiedenartigsten Ausführungsformen bekannt. Die gebräuchlichsten Realisierungen enthalten entweder einen einzelnen thermischen Sensor, der eine zur absorbierten elektrischen Leistung proportionale elektrische Meßgröße erzeugt, oder sie enthalten einen einzelnen Diodengleichrichter in Ein- oder Zweiwegschaltung, der eine der Spannung am Abschlußwiderstand äquivalente elektrische Ausgangangsgröße liefert, aus der dann die zu messende Leistung bestimmt werden kann. Während Leistungssensoren mit Dioden die Leistung von CW-Signalen (unmodelierte Sinussginale) über einen Bereich von -70 dBm bis +20 dBm genau messen können, ist ihre Verwendung im Zusammenhang mit hüllkurvenmodulierten Signalen auf den sogenannten quadratischen Kennlinienteil der Diode von -70 dBm bis etwa -20 dBm beschränkt. Der hier erzielbare Dynamikbereich von etwa 50 dB ist deutlich kleiner als bei CW-Signalen und etwa genauso groß wie bei thermischen Sensoren.

Insbesondere die Anforderungen der Kommunikationsstandards für die 2. und 3. Generation im digitalen Mobilfunk führten zur Entwicklung einer neuen Gruppe von Leistungssensoren mit einem wesentlich größeren Dynamikbereich für modulierte Signale. Bei einem dieser bekannten Leistungssensoren sind zwei Sensorzweige vorgesehen, und zwar ist ein erster Sensorzweig zum Messen in einem niedrigen Leistungs-Meßbereich unmittelbar am Eingang vorgesehen, und ein zweiter Sensorzweig zum Messen in einem hohen Leistungs-Meßbereich ist über ein spezielles Widerstandsnetzwerk, das sowohl als wellenwiderstandsrichtiger Abschluß für den ersten Sensorzweig als auch zur Leistungszufuhr für den zweiten Sensorzweig dient, mit dem Eingang verbunden (US-Patent 4,943,764). Bei der praktischen Ausführung dieses bekannten Leistungssensors muß der empfindliche eingangsseitige Sensorzweig abgeschaltet werden, wenn der andere Sensorzweig für hohe Leistungen benutzt wird (Hogan, R.: Wide-Range Sensor Gauges Power Of Complex Signals. Microwaves & RF, Sept. 1999, S. 128-137). Der Meßbereich des realisierten Leistungssensors ist von -60 dBm bis + 20 dBm spezifiziert, was bedeutet, daß die Empfindlichkeit um 10 dB geringer ist, als mit bekannten Leistungssensoren für CW-Signale erreichbar ist (Datenblatt "EPM Series Power Meters, E-Series and 8480 Series Power Sensors", Literaturnummer 5965-6382E der Fa. Agilent Technologies). Der Sensor ist in einer 6-GHz und in einer 18-GHz-Ausführung erhältlich.

Es ist auch schon ein Leistungssensor mit zwei Sensorzweigen bekannt, der über einen Leistungsteiler die zu messende Signalleistung in zwei Sensorzweige mit jeweils unterschiedlich großen Dämpfungsgliedern zum Messen der Signalleistung in einem niederen Leistungsbereich und einem hohen Leistungs-Meßbereich zuführt (US-Patent 4,873,484) . Der hierbei verwendete Leistungsteiler ist als sogenannter Drei-Widerstands-Powersplitter ausgebildet (Russel A. Johnson: Understanding Microwave Power Splitters, Microwave Journal Vol. 18, Dez. 1975, S. 49-56). Bei solchen mit Leistungsteilern arbeitenden Leistungssensoren ist es auch schon bekannt, zwei solche Drei-Widerstands-Powersplitter (auch resistive Power Divider genannt) in Kaskade anzuordnen und so insgesamt drei Sensorzweige für unterschiedliche Leistungs-Meßbereiche zu schaffen (Anritsu Co.: A Universal Power Sensor. Microwave Journal, März 2000, S. 130-134). Der vom Hersteller für diesen Leistungssensor spezifizierte Meßbereich beträgt ebenfalls nur -60 dBm bis + 20 dBm. Der Sensor ist nur in einer 6-GHz-Ausführung erhältlich.

Schließlich ist es bei Leistungssensoren mit Dioden auch schon bekannt, als gleichrichtendes Element mehrere gleichsinnig in Serie geschaltete Dioden zu verwenden, entweder um bei Sensoren, die ausschließlich für CW-Signale benutzt werden, den Einfluß der aussteuerungsabhängigen Sperrschichtkapazität auf die Linearität des Sensors zu verringern (US-Patent 5,204,613) oder um bei Sensoren für modulierte Signale den Meßbereich eines Sensorzweigs zu vergrößern (Hogan, R.: Wide-Range Sensor Gauges Power Of Complex Signals. Microwaves & RF, Sept. 1999, S. 128-137).

Es ist Aufgabe der Erfindung, einen Leistungssensor für die Messung des Leistungsmittelwerts modulierter Signale im Frequenzbereich bis 18 GHz oder höher zu schaffen, dessen Empfindlichkeit und Dynamikbereich größer ist als bei den bekannten Lösungen und vergleichbar mit den Eigenschaften von Leistungssensoren für CW-Signale.

Diese Aufgabe wird ausgehend von einem Leistungssensor laut Oberbegriff des Hauptanspruches durch die Kombination der an sich bekannten kennzeichnenden Merkmale gelöst. Vorteilhafte Weiterbildungen ergeben sich aus den Unteransprüchen.

Gemäß der Erfindung sind mindestens drei voneinander unabhängige Sensorzweige mit entsprechend unterschiedlichen Leistungs-Meßbereichen vorgesehen, um den geforderten Dynamikbereich von 90 dB so fein aufzuteilen, daß die an den Meßbereichsgrenzen der einzelnen Sensorzweige vorhandenen störenden Einflüsse durch Rauschen bzw. Fehler bei der Effektivwertgleichrichtung ausreichend klein gehalten werden können. Die einzelnen Sensorzweige enthalten vorzugsweise Dioden-Detektoren, die in an sich bekannter Weise mit einer einzigen Gleichrichterdiode (Einweggleichrichter) bzw. zwei Gleichrichterdioden unterschiedlicher Polung (Zweiweggleichrichter) und einem dazugehörigen Ladekondensator aufgebaut sind. Um die hohe Empfindlichkeit wie bei einem Leistungssensor für CW-Signale zu erreichen, ist ein erster Sensorzweig unmittelbar am Eingang angeordnet, während die anderen Sensorzweige über Leistungsteiler und Dämpfungsglieder mit entsprechend geteilten Leistungen gespeist werden. Besondere Bedeutung kommt dabei dem Gleichlauf der Sensorzweige über der Frequenz zu, da nur bei geringen Frequenzgangunterschieden ein problemloser .Wechsel von den Meßergebnissen des einen Zweiges auf die eines anderen möglich ist. Bei den bekannten Lösungen ist dies nicht gewährleistet.

Gemäß der Erfindung wird das Gleichlaufproblem dadurch gelöst, daß die Meßgröße, das ist die auf den Sensor auftreffende Welle, möglichst ungestört durch den ersten Sensorzweig geführt und anschließend durch einen Leistungsteiler mit weitgehend lastunabhängigem Gleichlaufverhalten (tracking) auf die beiden anderen Sensorzweige aufgeteilt wird. Die Meßvorrichtung im ersten Sensorzweig ist so zu gestalten, daß dessen Meßwert repräsentativ ist für die Höhe der Leistung der einfallenden. Welle unabhängig von der Anpassung des Leistungsteilers. Dazu werden im ersten Sensorzweig mehrere Spannungsabgriffe mit je einem zugeordneten Detektor in passenden Abständen auf der Zuleitung zum Leistungsteiler vorgesehen, und es wird in geeigneter Weise die Summe der Ausgangsspannungen der Detektoren bzw. der daraus ermittelbaren scheinbaren Leistungen gebildet. Durch die Summation wird die durch stehende Wellen auf der Zuleitung hervorgerufene Ortsabhängigkeit des Meßergebnisses verringert, wodurch sich die Leistung der einfallenden Welle sehr genau, weil weitgehend unabhängig von der Anpassung des Leistungsteilers und damit frequenzunabhängig messen läßt (Sucher, M.: Final Report on High Power Measuring Techniques; Microwave Research Institute, Report R-718-59, PIB-646, März 1959). Ein weiterer Vorteil einer solchen Anordnung mit verteilten Meßstellen besteht darin, daß sich die Störungen, die von den einzelnen Detektoren generiert werden, teilweise gegenseitig aufheben und so die eingangsseitige Anpassung des Leistungssensors verbessern. Obwohl die Vorteile der geschilderten Meßanordnung auf ein Frequenzband in der Größenordnung von ein bis zwei Oktaven beschränkt sind, macht ihre Anwendung auch in einem breitbandigen Leistungssensor mit einem sich über viele Oktaven erstreckenden Frequenzband Sinn, weil Störungen durch Fehlanpassung einzelner Baugruppen meist erst in den oberen zwei Dritteln des spezifizierten Frequenzbereichs relevant werden.

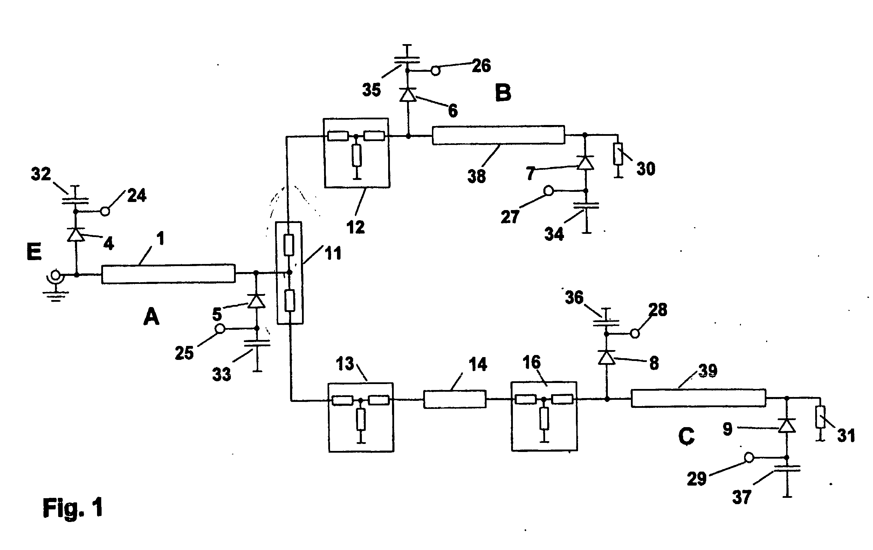

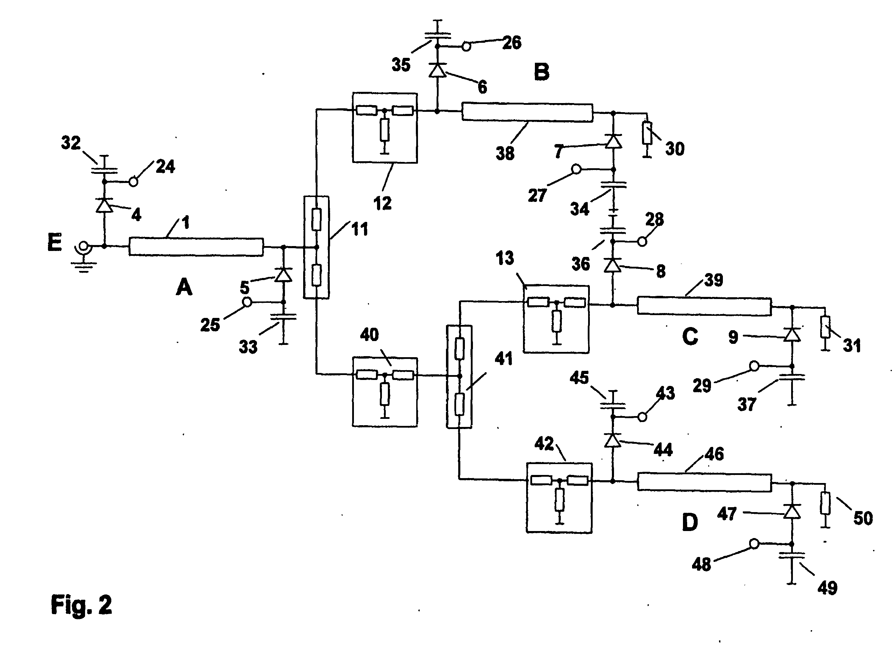

Zur symmetrischen Aufteilung des Meßsignals, unabhängig von Fehlanpassungen an den Ausgängen des Leistungsteilers, kommen zwei Ausführungsformen von Leistungsteilern in Betracht. Zur ersten Gruppe gehören solche, bei denen eine durch Fehlanpassung eines Ausgangs entstehende reflektierte Welle in demselben Maße zurückreflektiert wird, wie sie auf den anderen Ausgang übertragen wird, ausgedrückt durch die Beziehungen s₂₂ = s₃₂ und s₃₃ = s₂₃ zwischen den s-Parametern (Tor 1: Eingang des Leistungsteilers). Zur Gruppe dieser Art von Leistungsteilern gehört eine Anordnung, deren niederfrequentes Ersatzschaltbild durch je einen ohmschen Widerstand zwischen dem Eingang und den beiden Ausgängen wiedergegeben werden kann, wobei der Widerstandswert gleich dem verwendeten Wellenwiderstand ist (resistiver Power Splitter). Diese Anordnung ist in Fig. 1 und Fig. 2 dargestellt.

Als erfindungsgemäß können aber auch Leistungsteiler gelten, die ausgangsseitig angepaßt sind und eine hohe Isolation zwischen den Ausgängen haben (s₂₂ ≈ 0, s₃₃ ≈ 0, |s₂₃| << |s₂₁/s₃₁| und |s₃₂| << |s₃₁/s₂₁|), weil in diesem Fall eine durch die Beschaltung eines Ausgangs entstehende reflektierte Welle weder in diesen Ausgang zurückreflektiert noch auf den anderen Ausgang übertragen wird, wodurch das Verhältnis der ausgekoppelten Leistungen konstant bleibt. Zur Gruppe dieser Art von Leistungsteilern gehört u.a. der sog. Wilkinson-Divider (Webb, R.C.: Power Divider/Combiners: Small Size, Big Specs; Microwaves, Nov. 1981, S. 67-74).

Als nicht erfindungsgemäß sollen resistive Power Divider gelten, deren niederfrequentes Ersatzschaltbild drei von einem Sternpunkt ausgehende gleichgroße Widerstände zeigt, deren Widerstandswert gleich einem Drittel des Wellenwiderstandes ist. Weil bei diesem Typ eine durch die Beschaltung eines Ausgangs entstehende reflektierte Welle nicht in diesen Ausgang zurückreflektiert, wohl aber auf den anderen Ausgang übertragen wird (s₂₂ ≈ 0, s₃₃ ≈ 0, |s₂₃| ≈ 0, 25 und |s₃₂| ≈ 0,25), entsteht dadurch unmittelbar eine Unsymmetrie in der Leistungsaufteilung. Da Fehlanpassung wiederum frequenzabhängig ist, wird ein exakter Gleichlauf der beiden Ausgangsleistungen nicht möglich sein.

Von den beiden Ausgängen des ersten Leistungsteilers können über passend bemessene Dämpfungsglieder zwei in ihrem Leistungsbereich entsprechend gestaffelte Sensorzweige gespeist werden. Es ist aber auch möglich, an einem der beiden Ausgänge einen weiteren Leistungsteiler in der erfindungsgemäßen Ausführung vorzusehen, um so drei Ausgänge für insgesamt vier Sensorzweige zur Verfügung zu haben, was eine noch feinere Aufteilung des Leistungsbereiches ermöglicht (Fig. 2).

Bei einem erfindungsgemäßen Leistungssensor werden innerhalb eines Detektors vorteilhaft keine einzelnen Dioden, sondern mehrere in Serie geschaltete Dioden verwendet, weil sich dadaurch der Dynamikbereich eines einzelnen Sensorzweiges für die Messung modulierter Signale vergrößern läßt. Damit verbunden ist ein Gewinn an Aussteuerungsreserve an der oberen Meßgrenze des Leistungssensors, dem nur ein vergleichsweise geringer Verlust an Empfindlichkeit an der unteren Meßgrenze gegenübersteht. Ausgehend von einem Leistungsmeßbereich von -70 dBm bis +20 dBm für einen CW-Sensor mit einzelnen Dioden, wird die Serienschaltung von jeweils zwei Dioden die untere Meßgrenze des Sensors lediglich um 3 dB heraufsetzen (halbierte Empfindlichkeit), während die Aussteuerungsreserve um 6 dB steigt (halbierte Eingangsspannung pro Diode). Bei der Serienschaltung von 3 Dioden ist mit einer Verschiebung der unteren Meßgrenze um 5 dB und der oberen um 10 dB zu rechnen, und erst bei der Serienschaltung von 10 Dioden wird die Meßgrenze von -60 dBm der bekannten Lösungen mit mehreren Sensorzweigen erreicht.

Es ist außerdem vorteilhaft, die Ausgangssignale aller Sensorzweige gleichzeitig auszuwerten und das Meßergebnis in den Überlappungsbereichen von zwei benachbarten Sensorzweigen aus den Ausgangssignalen beider Zweige zu gewinnen. Die gleichzeitige Erfassung und parallele Weiterverarbeitung der an den Gleichrichtern der Sensorzweige gewonnenen Ausgangsspannungen erfolgt vorzugsweise mit einer Anordnung gemäß DE 199 55 342.4 der Anmelderin, d.h. die Ausgangsspannungen der Diodengleichrichter werden in einen Digitalwert umgesetzt und jeder dieser Digitalwerte wird mit Wichtungsfaktoren gewichtet, deren Verhältnis vom Aussteuerungsgrad mindestens eines der Diodengleichrichter abgeleitet wird. Diese so gewichteten Digitalwerte werden nach Skalierung auf eine gemeinsame Quantisierungseinheit zum eigentlichen digitalen Meßwert summiert und dann ausgewertet. In den Überlappungsbereichen zwischen zwei Sensorzweigen wird das Meßergebnis aus den Ausgangssignalen beider Gleichrichter gewonnen, wodurch sich die Einflüsse durch Rauschen und Fehler bei der Effektivwertgleichrichtung an den Meßbereichsgrenzen ausmitteln. Dadurch ist die Meßunsicherheit insgesamt sehr gering, und auch im Überlappungsbereich ist eine hohe Reproduzierbarkeit gewährleistet, weil die bei einer Umschaltung nötige Hysterese nicht gebraucht wird. Auch eine hohe Meßgeschwindigkeit wird erreicht, da ein Bereichswechsel überflüssig wird.

Die Erfindung wird im folgenden anhand schematischer Zeichnungen an Ausführungsbeispielen näher erläutert.

Fig. 1 zeigt das Prinzipschaltbild eines aus drei Sensorzweigen A, B und C bestehenden Leistungssensors. Das am Eingang E eingespeiste und auf Masse bezogene Eingangssignal, dessen Leistung gemessen werden soll, wird zunächst unmittelbar am Eingang einem ersten Sensorzweig A bestehend aus den räumlich versetzt angeordneten Detektoren 4 und 5 zugeführt; in diesem ersten Sensorzweig A wird die Signalleistung in einem niederen Leistungs-Meßbereich von beispielsweise -70 bis -16 dBm gemessen. Zwischen den beiden Detektoren 4 und 5 ist eine Leitung 1 angeordnet, die so dimensioniert ist, daß sie bei der höchsten Meßfrequenz des Leistungssensors näherungsweise die Länge λ/4 besitzt (λ = Wellenlänge) . Durch die mit der Leitung verbundenen Laufzeitunterschiede für einfallende und reflektierte Welle wird die an den Meßspannungsabgriffen 24, 25 abgegriffene Differenzspannung als Summe der Ausgangssignale der beiden Detektoren näherungsweise unabhängig von der Anpassung des nachfolgenden Leistungsteilers 11, und bleibt damit im gesamten Frequenzbereich proportional zur Eingangsleistung. Durch die mit der λ/4-Leitung erzeugten Laufzeitunterschiede werden außerdem die durch die Detektoren 4 und 5 erzeugten Reflexionen kompensiert, so daß zumindest im oberen Nutzfrequenzbereich eine deutliche Verbesserung der Anpassung am Eingang E erreicht wird. Anstelle von zwei Meßspannungsabgriffen könnten auch drei oder mehr verwendet werden, die bei geeigneter Dimensionierung der dazwischengeschalteten Leitungsabschnitte eine noch größere Unabhängigkeit der Leistungsmessung im empfindlichsten Sensorzweig von der Anpassung des Power Splitters 11 ermöglichen würden.

Die zu messende Signalleistung wird nach Durchlaufen des ersten Sensorzweigs unmittelbar einem resistiven Power Splitter 11 zugeführt, der durch die s-Parameter s₂₂ = s₃₂ und s₃₃ = s₂₃ gekennzeichnet ist und damit auch bei ausgangsseitiger Fehlanpassung eine symmetrische Aufteilung der Eingangsleistung ermöglicht. Die durch den Leistungsteiler 11 erzeugten gleich großen Signalleistungs-Anteile werden den beiden parallelen Sensorzweigen B und C zugeführt. Die beiden Sensorzweige B und C weisen zwei unterschiedlich bemessene Dämpfungsstufen 12 bzw. 13, 16 auf, die so bemessen sind, daß die beiden Detektoren 6, 7 bzw. 8, 9 jeweils für einen unterschiedlichen Meßbereich der Eingangsleistung ausgesteuert sind. In diesen Meßbereichen sind die an den Meßabgriffen 26, 27 bzw. 28, 29 abgreifbaren Differenz-Ausgangsspannungen proportional zu der am Eingang E zugeführten Signalleistung. Das Dämpfungsglied 12 des Sensorzweiges B ist beispielsweise so dimensioniert, daß vom Detektor 6, 7 der Eingangsleistungsbereich -22 bis +4 dBm abgedeckt wird, die Dämpfungsglieder 13, 16 des Sensorzweiges C mit dem Detektor 8, 9 sind so dimensioniert, daß durch diesen Zweig der Leistungsbereich -2 bis +20 dBm abgedeckt wird. Zusammen mit dem eingangsseitigen Sensorzweig A wird also insgesamt durch diese drei gleichzeitig wirksamen Sensorzweige ein großer Dynamikbereich erfaßt. Zwischen den einzelnen Detektoren 6, 7 bzw. 8, 9 dieser so gebildeten beiden zusätzlichen Sensorzweige B und C können wiederum Leitungen 38 bzw. 39 zwischengeschaltet werden, durch die Fehlanpassungen am Ausgang der Dämpfungsglieder und damit unerwünschte Dämpfungsänderungen über der Frequenz reduziert werden. Die Leitungen 1, 14, 38 bzw. 39 sind jeweils mit ihrem Wellenwiderstand abgeschlossen, die Leitung 1 durch den Eingangswiderstand des Leitungsteilers 11, die Leitung 14 durch den Eingangswiderstand des Dämpfungsglieds 16 und die Leitungen 38 und 39 durch die zusätzlichen Abschlußwiderstände 30, 31.

Die Dämpfung für den Sensorzweig C ist in zwei Stufen 13, 16 realisiert, wobei Dämpfungsglied 13 vorzugsweise identisch mit Dämpfungsglied 12 gewählt wird. Dadurch bleibt die Symmetrie der Anordnung bis zum Ausgang dieser Dämpfungsglieder erhalten, und es muß lediglich noch dafür gesorgt werden, daß das Dämpfungsglied 16 einen geringen Frequenzgang der Dämpfung aufweist. Die Anordnung mit zwei Dämpfungsstufen für Sensorzweig C hat aber noch den weiteren Vorteil, daß sich dieser Sensorzweig besser vom Meßeingang E isolieren läßt. Würde die gesamte Dämpfung für den Sensorzweig C im Dämpfungsglied 13 realisiert, so würde der Ausgang dieses Dämpfungsglieds einen gegenüber dem Meßeingang um 40 dB reduzierten Pegel führen, was wegen der räumlichen Nähe zum Power Splitter frequenzabhängiges Übersprechen nach sich zöge, was sich auch durch Verlängerung der Leitung 14 nicht reduzieren ließe. So aber führt die Leitung 14 einen Pegel, der so groß ist, daß das Übersprechen vom Meßeingang vernachlässigt werden kann, wodurch sich die Länge der Leitung 14 so bemessen läßt, daß der Sensorzweig C wiederum ausreichend entfernt vom Meßeingang E angeordnet werden kann. Schließlich lassen sich zwei Dämpfungswerte in der Größenordnung von jeweils 20 dB einfacher realisieren als ein einzelner in der Größenordnung von 40 dB.

Die drei Sensorzweige mit ihren Detektoren sind ohne kapazitive, induktive oder gemischt kapazitiv-induktive Koppelelemente jeweils direkt mit dem Eingang E bzw. den Dämpfungsgliedern 12, 16 verbunden.

Alle Schaltungskomponenten des Leistungssensors wie Leistungsteiler, Dämpfungsglieder und zugehörige Verbindungsleitungen sind nach hochfrequenztechnischen Gesichtspunkten ausgelegt. Der Leistungsteiler 11 besteht nicht nur jeweils aus zwei 50 Ω-Widerständen (für ein 50 Ω-Leitungssystem), sondern auch die damit verknüpften verteilten Kapazitäten und Induktivitäten werden in einem solchen Verhältnis zueinander gewählt, daß die s-Parameter über den gesamten Nutzfrequenzbereich die für einen solchen Leistungsteiler charakteristischen Werte besitzen. Dies bedeutet, daß bei Schaltungsabmessungen in der Größenordnung der kleinsten vorkommenden Wellenlänge ganz bestimmte Anforderungen an die Geometrie der Anordnung eingehalten werden müssen, ähnliches gilt für die Dämpfungsglieder und die Abschlußwiderstände 30, 31, sowie die Speiseleitungen und die verbindenden λ/4-Leitungen 1, 38 und 39. Der Aufbau der Gesamtschaltung in koplanarer Schaltungstechnik hat den Vorteil, daß die Schaltungsmasse in derselben Ebene liegt wie die Signalleiter, was einen besonders einfachen und preiswerten Gesamtaufbau ermöglicht.

Die Realisierung der Schaltung in Koplanartechnik ermöglicht auch die Verwendung von Dünnschicht-Kondensatoren für die Ladekapazitäten 32 bis 37 der Diodengleichrichter. Dünnschicht-Kondensatoren sind Kondensatoren extrem niedriger Bauhöhe, deren Bodenelektrode von einem Teil der Massefläche der Koplanarleitung gebildet wird, auf welchen ein dünnes Dielektrikum (Silicium-Nitrid, Silicium-Monoxid, ca. 1 *µ*m dick) aufgebracht wird, das wiederum mit einer Deckelelektrode versehen wird. Der große Vorteil solcher Dünnschicht-Kondensatoren liegt darin, daß diese Deckelelektrode praktisch in derselben Ebene wie die Masseflächen und Signalleitungen liegt und damit die Montage von Bauelementen gestattet, die mit sogenannten Bump-Kontaktflächen in einer Ebene ausgestattet sind. Solche Bumps ermöglichen sehr niedrige Anschlußinduktivitäten und damit ein besseres Hochfrequenzverhalten der Gleichrichter. Ferner stellt die quasi auf Massepotential und in einer Ebene mit der Massefläche liegende Deckelelektrode nur eine geringe Störung für das elektrische Feld benachbarter Leitungsstrukturen dar.

Zur Vergrößerung des Proportionalitätsbereiches zwischen Ausgangsspannung und Eingangsleistung der verwendeten Gleichrichter über den quadratischen Kennlinienteil hinaus ist es vorteilhaft, entweder in an sich bekannter Weise mehrere gleichsinnig in Serie geschaltete Dioden anstelle einer einzelnen Diode 4, 5, 6, 7, 8 und 9 vorzusehen, wobei Anordnung von drei solchen in Serie geschalteten Dioden beispielsweise einen Gewinn an Meßdynamik von bereits 5 dB ermöglicht, oder die Gleichrichter werden gemäß DE 199 13 338 der Anmelderin ausgebildet und dimensioniert, was einen Gewinn von ca. 10 dB bedeutet.

Eine noch feinere Unterteilung der Leistungs-Meßbereiche ist dadurch möglich, daß gemäß Fig. 2 mehrere Leistungsteiler hintereinander in Kaskade angeordnet werden. Durch die zwei in Kaskade geschalteten Leistungsteiler 11 und 41 werden insgesamt vier Sensorzweige A, B, C und D geschaffen, die Zweige A, B und C entsprechen denjenigen nach Fig. 1. Durch den zweiten Leistungsteiler 41, der von dem einen Zweig des ersten Leistungsteilers 11 über ein Dämpfungsglied 40 einen Teil der Leistung zugeführt bekommt, wird diese auf den Sensorzweig C und den vierten Sensorzweig D aufgeteilt, der wiederum ein Dämpfungsglied 42, einen Detektor 44, 47 mit dazwischen angeordneter Verzögerungsleitung 46 und zugehörigem Abschlußwiderstand 50 aufweist und dessen Meßausgänge 43, 48 wiederum mit der gemeinsamen digitalen Auswerteeinrichtung verbunden sind. Die so geschaffenen vier Sensorzweige können in ihrem nutzbaren Leistungsbereich feiner abgestuft werden, was im Überlappungsbereich zu einem noch besseren Signal-Rausch-Abstand und damit einer ebenfalls geringeren Meßunsicherheit bzw. höheren Meßgeschwindigkeit führt. Von den insgesamt zusätzlichen drei Dämpfungsgliedern 13, 40 und 42 sind nicht unbedingt alle drei erforderlich, bei entsprechender Auslegung kann auch eines dieser Dämpfungsglieder entfallen.

Eine andere Möglichkeit zur Erhöhung der Anzahl der Sensorzweige besteht darin, in Fig. 2 auch den Sensorzweig B durch einen weiteren Leistungsteiler in zwei weitere Sensorzweige aufzuteilen und so insgesamt fünf Sensorzweige zu schaffen, oder einen der schon unterteilten Sensorzweige C oder D durch einen weiteren in Kaskade zum Leistungsteiler 41 angeordneten Leistungsteiler wiederum in mehrere einzelne Sensorzweige aufzuteilen. Auf diese Weise können beliebig viele Sensorzweige realisiert werden, wobei der dadurch erzielte Gewinn gegenüber dem höheren Schaltungsaufwand und möglichen Gleichlaufproblemen abzuwägen ist.

Es ist vorteilhaft, sämtliche Bauteile in einem Meßkopf einzubauen.

## Patentansprüche

1. Leistungssensor zum Messen der mittleren Leistung modulierter oder unmodulierter Hochfrequenz- oder Mikrowellen-Signale über einen großen Dynamikbereich, mit einem unmittelbar am Eingang (E) angeschalteten ersten Sensorzweig (A) zum Messen in einem niedrigen Leistungs-Meßbereich und einem nachfolgenden zweiten Sensorabschnitt zum Messen in einem hohen Leistungs-Meßbereich,
**dadurch gekennzeichnet,**
**daß** der erste Sensorzweig (A) zum Messen der Signalleistung im niederen Leistungs-Meßbereich (-70 bis -16 dBm) mehrere räumlich voneinander getrennte Meßstellen (4,5) auf einer Verbindungsleitung (1) aufweist und dieser erste Sensorzweig (A) über einen Leistungsteiler (11), der das Eingangssignal unabhängig von Fehlanpassungen seiner Ausgänge symmetrisch auf diese Ausgänge aufteilt, im zweiten Sensorabschnitt über Dämpfungsglieder (12, 13, 16, 42) mit mindestens zwei weiteren Sensorzweigen (B, C bzw. D) zum Messen der Signalleistung in mindestens zwei weiteren unterschiedlichen Leistungs-Meßbereichen (-22 bis +4 dBm bzw. -2 bis +20 dBm) verbunden ist.

2. Leistungssensor nach Anspruch 1,
**dadurch gekennzeichnet,**
**daß** die zu messende Signalleistung über den Leistungsteiler (11) mit zwei weiteren Sensorzweigen (B, C) zum Messen der Signalleistung in einem mittleren und einem hohen Leistungs-Meßbereich verbunden ist.

3. Leistungssensor nach Anspruch 1,
**dadurch gekennzeichnet,**
**daß** die zu messende Signalleistung über zwei in Kaskade geschaltete Leistungsteiler (11, 41), die das Eingangssignal unabhängig von Fehlanpassungen ihrer Ausgänge symmetrisch auf diese Ausgänge aufteilen, über Dämpfungsglieder (12, 13, 16) mit drei weiteren Sensorzweigen (B, C und D) zum Messen der Signalleistung in drei weiteren unterschiedlichen Leistungs-Meßbereichen verbunden ist.

4. Leistungssensor nach einem der Ansprüche 1 bis 3,
**dadurch gekennzeichnet,**
**daß** der Leistungsteiler (11, 41) ein resistiver Power Splitter mit s₂₂ = s₃₂ und s₃₃ = s₂₃ ist.

5. Leistungssensor nach einem der Ansprüche 1 bis 4,
**dadurch gekennzeichnet,**
**daß** mindestens der erste Sensorzweig (A) aus zwei Meßstellen in einem Abstand von etwa einem Viertel der Wellenlänge der höchsten vorkommenden Frequenz besteht.

6. Leistungssensor nach einem der Ansprüche 1 bis 5,
**dadurch gekennzeichnet,**
**daß** die Sensorzweige jeweils Dioden-Gleichrichter aufweisen.

7. Leistungssensor nach Anspruch 6,
**dadurch gekennzeichnet,**
**daß** mindestens einer der Dioden-Gleichrichter als ZweiwegGleichrichter (4,5;6,7;8,9;44,47) ausgebildet ist.

8. Leistungssensor nach Anspruch 7,
**dadurch gekennzeichnet,**
**daß** zwischen den beiden Gleichrichterzweigen der Doppelweg-Gleichrichter in den weiteren Sensorzweigen (B, C D) jeweils mit ihrem Wellenwiderstand abgeschlossene Verzögerungsleitungen (38,39,46) angeordnet sind.

9. Leistungssensor nach einem der vorhergehenden Ansprüche 6 bis 8,
**dadurch gekennzeichnet,**
**daß** mindestens einer der Dioden-Gleichrichter aus der Serienschaltung von mehreren, vorzugsweise drei gleichsinnig angeordneten Dioden besteht.

10. Leistungssensor nach einem der vorhergehenden Ansprüche,
**dadurch gekennzeichnet,**
**daß** der Signal-Eingang und mindestens einer der Meßzweige in koplanarer Leitungstechnik ausgebildet ist.

11. Leistungssensor nach Anspruch 10,
**dadurch gekennzeichnet,**
**daß** die Ladekapazitäten der in Koplanartechnik ausgeführten Meßzweige als Dünnschichtkondensatoren ausgebildet sind.

12. Leistungssensor nach einem der vorhergehenden Ansprüche,
**dadurch gekennzeichnet,**
**daß** die Ausgangssignale der Diodengleichrichter der Meßzweige in einen Digitalwert umgesetzt werden, jeder dieser Digitalwerte mit Richtungsfaktoren gewichtet, deren Verhältnis vom Aussteuerungsgrad mindestens eines der Diodengleichrichter abgeleitet wird, und diese gewichteten Digitalwerte nach Skalierung auf eine gemeinsame Quantisierungseinheit zum eigentlichen digitalen Meßwert summiert werden.

13. Leistungssensor nach Anspruch 12,
**dadurch gekennzeichnet,**
**daß** das Meßergebnis in digitaler Form ausgegeben wird.

14. Leistungssensor nach einem der vorhergehenden Ansprüche,
**dadurch gekennzeichnet,**
**daß** seine sämtlichen Bestandteile in einem Meßkopf eingebaut sind.

## Claims

1. Power sensor for measuring the average power of modulated or unmodulated radiofrequency or microwave signals over a large dynamic range, having a first sensor branch (A) connected directly to the input (E) for measurement in a low power measurement range and a subsequent second sensor section for measurement in a high power measurement range
**characterised in that**
the first sensor branch (A) for measuring the signal power in the low power measurement range (-70 to -16 dBm) comprises a plurality of mutually spatially separated measurement points (4, 5) on a connection line (1), and this first sensor branch (A) is connected via a power splitter (11) in the second sensor section, which distributes the input signal symmetrically between its outputs independently of mismatches of these outputs, via attenuators (12, 13, 16, 42) to at least two further sensor branches (B, C and/or D) for measuring the signal power in at least two further different power measurement ranges (-22 to +4 dBm and -2 to +20 dBm).

2. Power sensor according to Claim 1,
**characterised in that**
the signal power to be measured is connected via the power splitter (11) to two further sensor branches (B, C) for measuring the signal power in a medium and a high power measurement range.

3. Power sensor according to Claim 1,
**characterised in that**
the signal power to be measured is connected via two power splitters (11, 41) connected in cascade, which distribute the input signal symmetrically between their outputs independently of mismatches of these outputs, via attenuators (12, 13, 16) to three further sensor branches (B, C and D) for measuring the signal power in three further different power measurement ranges.

4. Power sensor according to one of Claims 1 to 3,
**characterised in that**
as the power splitter (11, 41) is a resistive power splitter with s₂₂ = s₃₂ and s₃₃ = s₂₃.

5. Power sensor according to one of Claims 1 to 4,
**characterised in that**
at least the first sensor branch (A) consists of two measurement points at a separation of approximately one quarter of the wavelength of the highest occurring frequency.

6. Power sensor according to one of Claims 1 to 5,
**characterised in that**
the sensor branches respectively comprise diode rectifiers.

7. Power sensor according to Claim 6,
**characterised in that**
at least one of the diode rectifiers is designed as a two-way rectifier (4, 5; 6, 7; 8, 9; 44, 47).

8. Power sensor according to Claim 7,
**characterised in that**
delay lines (38, 39, 46), respectively terminated with their characteristic impedance, are arranged between the two rectifier branches of the dual-way rectifiers in the further sensor branches (B, C D).

9. Power sensor according to one of the preceding Claims 6 to 8,
**characterised in that**
at least one of the diode rectifiers consists of the series connection of a plurality of, preferably three, diodes arranged in the same direction.

10. Power sensor according to one of the preceding claims,
**characterised in that**
the signal input and at least one of the measurement branches is designed in coplanar line technology.

11. Power sensor according to Claim 10,
**characterised in that**
the charging capacitances of the measurement branches embodied in coplanar technology are designed as thin-film capacitors.

12. Power sensor according to one of the preceding claims,
**characterised in that**
the output signals of the diode rectifiers of the measurement branches are converted into a digital value, each of these digital values is weighted with direction factors whose ratio is derived from the drive level of at least one of the diode rectifiers, and these weighted digital values are summed to form the actual digital measurement value after scaling to a common quantisation unit.

13. Power sensor according to Claim 12,
**characterised in that**
the measure result is output in digital form.

14. Power sensor according to one of the preceding claims,
**characterised in that**
all the components are built into a measurement head.

## Revendications

1. Capteur de puissance pour mesurer la puissance moyenne de signaux à haute fréquence ou signaux à hyperfréquence modulés ou non modulés sur une grande plage dynamique, comprenant une première branche de capteur (A) branchée directement à l'entrée (E) pour la mesure dans une plage de mesure de puissance faible et une seconde partie de capteur consécutive pour la mesure dans une plage de mesure de puissance élevée,
**caractérisé en ce que**,
la première branche de capteur (A) pour la mesure de la puissance de signal dans la plage de mesure de puissance faible (-70 jusqu'à -16 dBm) présente plusieurs points de mesure (4, 5) séparés dans l'espace les uns des autres sur une ligne de liaison (1) et cette première branche de capteur (A) est reliée au moyen d'un diviseur de puissance (11), qui répartit le signal d'entrée indépendamment des désadaptations de ses sorties de façon symétrique entre ces sorties, dans la seconde partie de capteur au moyen d'atténuateurs (12, 13, 16, 42) à au moins deux autres branches de capteur (B, C ou D) pour la mesure de la puissance de signal dans au moins deux autres plages de mesure de puissance différentes (-22 jusqu'à +4 dBm ou -2 jusqu'à +20 dBm).

2. Capteur selon la revendication 1,
**caractérisé en ce que**,
la puissance de signal à mesurer est reliée par le diviseur de puissance (11) à deux autres branches de capteur (B, C) pour la mesure de la puissance de signal dans une plage de mesure de puissance moyenne et une plage de mesure de puissance élevée.

3. Capteur de puissance selon la revendication 1,
**caractérisé en ce que**,
la puissance de signal à mesurer est reliée au moyen de deux diviseurs de puissance (11, 41) branchés en cascade, qui répartissent le signal d'entrée indépendamment de désadaptations de leurs sorties de façon symétrique entre ces sorties, par des atténuateurs (12, 13, 16) à trois autres branches de capteur (B, C et D) pour la mesure de la puissance de signal dans trois autres plages de mesure de puissance différentes.

4. Capteur de puissance selon l'une quelconque des revendications 1 à 3,
**caractérisé en ce que**,
le diviseur de puissance (11, 41) est un diviseur de puissance résistif avec s₂₂ = s₃₂ et s₃₃ = s₂₃.

5. Capteur de puissance selon l'une quelconque des revendications 1 à 4,
**caractérisé en ce que**,
au moins la première branche de capteur (A) comprend deux points de mesure à une distance d'environ un quart de longueur d'onde de la fréquence maximale rencontrée.

6. Capteur de puissance selon l'une quelconque des revendications 1 à 5,
**caractérisé en ce que**,
les branches de capteur présentent respectivement des redresseurs à diodes.

7. Capteur de puissance selon la revendication 6,
**caractérisé en ce que**,
au moins un des redresseurs à diodes est conçu comme un redresseur pleine onde (4, 5 ; 6, 7 ; 8, 9 ; 44, 47).

8. Capteur de puissance selon la revendication 7,
**caractérisé en ce que**,
entre les deux branches de redresseur des redresseurs pleine onde et dans chacune des deux autres branches de capteur (B, C, D) sont disposées des lignes de temporisation (38, 39, 46) terminées par leur résistance d'onde.

9. Capteur de puissance selon l'une quelconque des revendications précédentes 6 à 8,
**caractérisé en ce que**,
au moins l'un des redresseurs à diodes comprend le montage en série de plusieurs, de préférence trois diodes disposées dans le même sens.

10. Capteur de puissance selon l'une quelconque des revendications précédentes,
**caractérisé en ce que**,
l'entrée du signal et au moins l'une des branches de mesure est conçue dans une technique de ligne coplanaire.

11. Capteur de puissance selon la revendication 10,
**caractérisé en ce que**,
les capacités de chargement des branches de mesure réalisées dans la technique coplanaire sont conçues comme des condensateurs à couche mince.

12. Capteur de puissance selon l'une quelconque des revendications précédentes,
**caractérisé en ce que**,
les signaux de sortie des redresseurs à diodes des branches de mesure sont convertis dans une valeur numérique, chacune de ces valeurs numériques est pondérée avec des facteurs de direction, dont le rapport est déduit du degré de modulation d'au moins l'un des redresseurs à diodes, et ces valeurs numériques pondérées sont totalisées après un accord sur une unité de quantification commune pour former la valeur de mesure numérique proprement dite.

13. Capteur de puissance selon la revendication 2,
**caractérisé en ce que**,
le résultat de la mesure est sorti sous une forme numérique.

14. Capteur de puissance selon l'une quelconque des revendications précédentes,
**caractérisé en ce que**,
tous ses composants sont intégrés dans une tête de mesure.
